(19) Europäisches Patentamt
European Patent Office
Office européen des brevets

(11) **EP 3 723 290 A1**

(12) **EUROPÄISCHE PATENTANMELDUNG**

(43) Veröffentlichungstag:
**14.10.2020 Patentblatt 2020/42**

(51) Int Cl.:
***H03K 17/30*** *(2006.01)*     ***G05B 19/05*** *(2006.01)*
***H03K 17/60*** *(2006.01)*     ***H03K 17/795*** *(2006.01)*

(21) Anmeldenummer: **20020172.1**

(22) Anmeldetag: **09.04.2020**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: **10.04.2019 DE 102019002640**

(71) Anmelder:
- **Hilscher SoC Technology GmbH**
  **10961 Berlin (DE)**
- **Hilscher, Hans Jürgen**
  **65795 Hattersheim (DE)**

(72) Erfinder: **Raehse, Norbert**
**D-14612 Falkensee (DE)**

(74) Vertreter: **Dreykorn-Lindner, Werner**
**Steinlachstrasse 2**
**90571 Schwaig (DE)**

(54) **BAUGRUPPE MIT EINER SCHNITTSTELLENSCHALTUNG MIT EINER STROMSENKE ODER -QUELLE MIT OPTIMIERTER VERTEILUNG DER VERLUSTLEISTUNG**

(57) 1. Baugruppe mit einer Schnittstellenschaltung mit einer Stromsenke oder - quelle mit optimierter Verteilung der Verlustleistung.

2.1 Es sind je nach Anwendungsfall unterschiedlich ausgestaltete Schnittstellen/Geräte seit langem bekannt,

2.2 Um eine Schnittstellenschaltung einer Baugruppe für den Anschluss mehrerer Signalquellen derart auszugestalten, dass eine Verlustleistungsreduktion an der kostenintensiven integrierten Schaltung innerhalb der Baugruppe ermöglicht wird, um die Anzahl der Kanäle pro integrierter Schaltung zu erhöhen und somit die Kosten pro Kanal zu senken, ist eine Baugruppe (6) mit mindestens einer Schnittstellenschaltung (1) für den Anschluss einer Signalquelle (4), welche innerhalb einer integrierten Schaltung (5) und außerhalb der integrierten Schaltung (5) angeordnete Bauelemente aufweist, vorgesehen, wobei die Schnittstellenschaltung (1) derart ausgestaltet ist, dass:

- innerhalb der integrierten Schaltung (5) befindet sich eine spannungsabhängig geregelte Stromquelle oder Stromsenke (2),
- außerhalb der integrierten Schaltung (5) befindet sich ein Bauelement (3) und
- das Bauelement (3) ist zur Stromquelle oder Stromsenke (2) parallel geschaltet, wobei die Stromquelle oder Stromsenke (2) spannungsabhängig so geregelt wird, dass der Summenstrom (Iin) aus Strom (Ia) der Stromquelle oder Stromsenke (2) und Strom (Ip) aus dem passiven Bauelement (3) eine geringere Spannungsabhängigkeit aufweist als der Strom (Ip) vom passiven Bauelement (3) allein, derart, dass eine Umverteilung der Verlustleistung innerhalb der Schnittstellenschaltung (1) erfolgt.

2.3 Die Erfindung liegt auf dem Gebiet der Schnittstellenschaltungen für Baugruppen.

Fig. 1

**Beschreibung**

Die Erfindung betrifft-eine Schnittstellenschaltung einer Baugruppe für den Anschluss einer Signalquelle. Die mindestens eine Schnittstellenschaltung der Baugruppe weist Komponenten innerhalb und außerhalb einer integrierten Schaltung auf, wobei mehrere dieser Schnittstellenschaltungen zum Anschluss mehrerer Sensoren eine gemeinsame integrierte Schaltung verwenden.

Die kontinuierliche voranschreitende Vernetzung der Produktion führt dazu, dass Maschinen mit immer mehr Sensoren ausgerüstet werden. In der Automatisierungstechnik sind Sensoren an dezentralen Ein- /Ausgangskomponenten angeschlossen und diese wiederum wie Antriebe, RFID-Controller und andere Peripheriegeräte über ein echtzeitfähiges Real-Time Ethernet Netzwerk untereinander und mit der Steuerung verbunden.

Digitale Eingangsmodule, die in der Automatisierungstechnik (Industrie- und Gebäudeautomation) verwendet werden, können zwischen mehrere, sogar tausende digitale Eingänge oder "Kanäle" für die Verbindung mit verschiedenen Sensoren und Schaltern enthalten. Diese Module werden normalerweise in Verbindung mit einem speziellen Mikrocomputer verwendet, der als speicherprogrammierbare Steuerung oder SPS bezeichnet wird. Bei einem typischen digitalen Eingangsmodul nach dem Stand der Technik kann jeder Eingang im "Ein" - Zustand beispielsweise 100 bis 300 mW Leistung von der Stromversorgung des Moduls beziehen. Dieser hohe Stromverbrauch begrenzt die Dichte (und damit die maximale Anzahl) von Kanälen, die von digitalen Eingangsmodulen des Standes der Technik, aufgrund von Konstruktionsanforderungen, einschließlich Wärmeableitung und maximalem Stromverbrauch, bereitgestellt werden können. Diese Begrenzung gilt insbesondere, wenn möglichst viele Kanäle auf einer gemeinsamen integrierten Schaltung integriert werden sollen, um die Kosten pro Kanal zu senken.

Ein digitales Eingangsmodul ist in erster Linie für die Erkennung von binären (Ein / Aus) Signalen von digitalen Sensoren wie Näherungssensoren, Füllstandsensoren, Endschaltern, Drucktastern usw. verantwortlich, die mit einer hohen Spannung von nominell etwa 24 Volt Gleichspannung und mit einer maximalen Gleichspannung von 30 V arbeiten. Das digitale Eingangsmodul wandelt die "Hochspannungs"-Sensorsignale in Signale mit niedrigerer Spannung um (z.B. 5 V Gleichspannung), die von der SPS verarbeitet werden können. Ein digitales Eingangsmodul filtert die Sensorsignale und kann eine galvanische Trennung der "Hochspannungs"-Sensoren von der "Niederspannungs"-SPS für die Sicherheit von Bedienern sowie für einen zuverlässigen Betrieb der Niederspannungssteuerschaltkreise bereitstellen. Die Norm IEC 61131-2: 2007 (International Electrotechnical Commission Genf, Schweiz) beschreibt drei Arten von Digitaleingängen Typ 1, Typ 2 und Typ 3. Darin werden folgende Werte angegeben:

**Typ 1:** High-Pegel bei $\geq$ 15 V (Stromaufnahme $\geq$ 2 mA), Low-Pegel bei $\leq$ 5 V.
**Typ 2:** High-Pegel bei $\geq$ 11 V (Stromaufnahme $\geq$ 6 mA), Low-Pegel bei $\leq$ 5 V.
**Typ 3:** High-Pegel bei $\geq$ 11 V (Stromaufnahme $\geq$ 2 mA), Low-Pegel bei $\leq$ 5 V.

Digitale Eingänge bzw. IO-Link Empfänger, die IEC-61131-2 (derzeit Jahr 2007) oder IEC-61131-9 (derzeit Jahr 2013) erfüllen, benötigen eine Stromsenke, die einer im Standard vorgeschriebenen Kennlinie folgt. Soll die Stromsenke kostengünstig und größtenteils im Chip integrierbar, ohne Verwendung von geschalteten Induktivitäten realisiert werden, ergibt sich eine unumgängliche Verlustleistung im System, definiert durch den minimal im Standard erforderlichen Strom (6 mA bei Typ 2 Eingang) und die maximal erlaubte Spannung (30 V) von 180 mW.

Soll ein Mehrkanalsystem realisiert werden, z.B. 8 Kanäle, multipliziert sich die Verlustleistung entsprechend. Eine Integration aller Stromsenken auf einem einzigen Chip würde dessen thermisches Budget überfordern, oder es ist eine aufwändige Kühlung erforderlich.

Da die Verlustleistung im Gesamtsystem jedoch verkraftbar ist, kann man versuchen, einen großen Teil der Verlustleistung auf externe Bauteile auszulagern.

Nach aktuellem Stand der Technik existieren folgenden Lösungsansätze zur Realisation von digitalen Eingängen:

a) Aufbau mit diskreten Bauelementen und voller Verlustleistung. Die Verlustleistung kann über die Vielzahl der Bauteile abgeführt werden.

Beispielsweise kann eine diskrete Widerstandsteilerschaltung verwendet werden, um eine vordefinierte Spannungsschwelle zu erfassen und einen Optokoppler einzuschalten, sobald eine Spannungsschwelle und eine Stromschwelle überschritten werden. Der Optokoppler dient zur galvanischen Trennung zwischen der "Hochspannungs"-Seite der Widerstandsteilerschaltung (z. B 24 VDC-Spitzenamplitude) und der "Niederspannungs"-Seite der Widerstandsteilerschaltung (z.B. 10 V Spitzenamplitude) als auch als Spannungspegelumsetzer, um ein 5 V-Binärsignal, das den Zustand des Sensors darstellt, an eine SPS zu liefern. Ferner sind Kondensatoren vorgesehen, welche einen Teil eines Tiefpassfilters bilden, um das durch die Aktivierung des Sensors erzeugte Eingangssignal zu entprellen. Die Widerstandsteilerschaltung hat den Vorteil der Wirtschaftlichkeit, da sie relativ kostengünstig zu implementieren ist. Ein Problem der Widerstandsteilerschaltung besteht darin, dass sie einen hohen Stromverbrauch aufweist, da der Strom kontinuierlich durch die Teilerwiderstände fließt, wenn der Sensor aktiviert ist. Tatsächlich steigt bei der Widerstandsteilerschaltung der durch die Gleichung $P = U^2 I$ angegebene Energieverbrauch quadratisch mit der Sensorspannung an, da der Strom gemäß dem Ohm'schen Gesetz linear ansteigt: $I = U / R$. Der Energieverbrauch der Widerstandsteilerschaltung bei aktiviertem Sensor (beispielsweise ist der Schalter geschlossen) beträgt daher $P = Us^2 / R$, wobei Us die Feldspannung ist. Nachteile sind somit: viele Bauteile, viel Platz.

Bei einer anderen Lösung ist eine Strombegrenzungsschaltung vorgesehen, die einen Eingangswiderstand, einen Eingangskondensator, einen Strombegrenzer, einen Spannungs- / Stromkomparator, ein Tiefpassfilter und einen Taktgeber/Oszillator enthält. Ein Sensor koppelt den Eingangswiderstand an eine 24 V Gleichspannungsversorgung. Im Betrieb ermöglicht die Strombegrenzungsschaltung, dass der Strom mit der durch den Sensor bereitgestellten Spannung bis zu einer Erfassungsschwelle linear ansteigt, und wird dann durch den Strombegrenzer an einem weiteren Anstieg gehindert. Es ist keine weitere Erhöhung des Eingangsstroms möglich, da die Sensorspannung auf ihren durch die Feldstromversorgung eingestellten maximalen Pegel ansteigt. Der Detektor wird verwendet, um den binären Zustand des Sensors zu erfassen und ihn auf 5 V umzuwandeln. Das durch den Taktgeber getaktete digitale Tiefpassfilter wird dann nach dem Detektor verwendet, um das Sensorsignal zu filtern und zu entprellen. Die Strombegrenzer-Schaltung verbraucht weniger Strom als die Widerstandsteilerschaltung, da der Strombegrenzer den maximalen Strom begrenzt, der dem Hochspannungssensor entnommen werden kann. Der Strombegrenzer zieht jedoch weiterhin Strom auf dem Strombegrenzungspegel ("Klemm" -Pegel) $i_L$, solange sich der Sensor -Ausgang auf einem hohen Spannungspegel befindet. Während der Stromverbrauch der Strombegrenzerschaltung geringer ist als der Energieverbrauch der Widerstandsteilerschaltung verbraucht die Strombegrenzungsschaltung immer noch eine beträchtliche Menge an Energie, wodurch die Kanaldichte begrenzt werden kann und größere Stromversorgungen erforderlich sind.

b) voll integrierte Lösungen mit bis zu 8 Kanälen pro Chip und voller Verlustleistung. Die Verlustleistung beschränkt die Anzahl der Kanäle auf 8 Kanäle (IEC-61131-2, Typ 1/3: >2mA) bzw. auf 4 Kanäle ((IEC-61131-2, Typ 2: >6mA). Nachteilig ist, dass die volle Verlustleistung im Chip abfällt und auch die Integration weiterer Komponenten, wie z.B. IO-Link Verarbeitung, begrenzt ist.

Um die baugruppenseitig anfallende Verlustleistung zu reduzieren und damit z.B. Baugruppen mit verringerter Baugröße oder Baugruppen mit zumindest im Wesentlichen gleich bleibender Baugröße, bei denen jedoch die gesamte oder zumindest eine höhere Anzahl von Eingangskanälen gleichzeitig verwendbar ist, realisieren zu können, ist beispielsweise aus der EP 1 770 456 B1 eine Peripheriebaugruppe für ein Automatisierungsgerät bekannt, welche mindestens einem als verlustleistungsoptimierten Digitaleingang fungierenden Signalkontakt zum Anschluss eines baugruppenexternen Sensors zumindest an den Signalkontakt aufweist. Bei einer Peripheriebaugruppe der vorstehend genannten Art ist oder sind dazu Mittel zur Ausspeisung (Ausspeisungsmittel) einer über zumindest den Signalkontakt einspeisbaren elektrischen Energie vorgesehen. Hierzu ist zumindest ein Versorgungskontakt zum Anschluss des Sensors an die Peripheriebaugruppe und Mittel zur zumindest teilweisen Ausspeisung (Ausspeisungsmittel) von über zumindest den Signalkontakt einspeisbarer elektrischer Energie über den Versorgungskontakt vorgesehen. Dabei wird von der Erkenntnis ausgegangen, dass immer wenn ein Digitaleingang Strom aufnimmt, also Strom in die Baugruppe über den Signalkontakt aufgrund einer außen (über dem Sensor) anliegenden Spannung eingespeist wird, innerhalb der Baugruppe eine Verlustleistung entsteht. Anstatt diese Leistung wie bisher üblich in Wärme umzusetzen, wird sie mittels des oder der Ausspeisungsmittel auf ein nutzbares Spannungsniveau gebracht und von der Baugruppe wieder ausgespeist, d.h. als Ausgangsspannung und Ausgangsstrom wieder zum über den Signalkontakt und Versorgungskontakt angeschlossenen Sensor abgegeben. Die Baugruppe gibt damit elektrische Energie in Form von Strom und/oder Spannung aus. Sie erzeugt praktisch eine AusgangsLeistung aus der über den oder die Signalkontakt(e) eingespeisten Leistung und verhindert oder zumindest verringert dadurch das Entstehen von Verlustleistung im Bereich der Baugruppe. Demzufolge wird ein Teil der als Eingangsstrom durch die Baugruppe aufgenommenen elektrischen Energie damit unmittelbar zur elektrischen Versorgung des jeweiligen Sensors zurückgeführt. Dadurch, dass das oder die Ausspeisungsmittel als Schaltregler ausgeführt ist bzw. ausgeführt sind, lässt sich gewährleisten, dass die elektrische Energie, also der Strom und die Spannung, den bzw. die die Baugruppe insbesondere über den Versorgungskontakt, wieder ausspeist, mit hohem Wirkungsgrad und geringer Verlustleistung erzeugt wird. Mit einem solchen Schaltregler ist es bei geeigneter Konfiguration und Parametrierung möglich, dass die ausgespeiste Ausgangsspannung so groß wird, dass sie auf eine ebenfalls an den Versorgungskontakt extern angeschlossene Baugruppenversorgung über diesen einen Strom hinaustreiben kann. Der abgegebene, ausgespeiste Strom hängt dabei von der Leistung ab, die am jeweiligen Digitaleingang in die Baugruppe eingespeist wird. Zum Erreichen eines solchen hohen Wirkungsgrades ist das oder sind die Ausspeisungsmittel bevorzugt in Form eines getakteten Hochstellers mit Konstantstromsenke ausgeführt oder der Schaltregler umfasst zumindest einen solchen getakteten Hochsteller mit Konstantstromsenke. Die Verluste können dadurch auf etwa 30% der bei den bisherigen Lösungskonzepten anfallenden Verluste reduziert werden. Dies bedeutet, dass die dreifache Anzahl von Digitaleingängen bei gleicher Baugröße realisiert werden kann. Dadurch werden hochkanalige Baugruppen ohne Derating realisierbar. Bevorzugt ist oder sind das bzw. die Ausspeisungsmittel, also insbesondere der Schaltregler bzw. der getaktete Hochsteller mit Konstantstromsenke, durch Integration in einen sog. ASIC realisiert. Die Verwendung eines ASICs hat den Vorteil, dass zusätzlich noch die Integration von Funktionalität zur Kurzschluss- und Drahtbruch-Überwachung für den jeweiligen Digitaleingang in den ASIC integrierbar ist. Zum Auswerten des jeweiligen Status des anschließbaren oder angeschlossenen Sensors ist vorgesehen, dass das oder die Ausspeisungsmittel Verarbeitungsfunktionalität umfasst bzw. umfassen, derart, dass anhand einer Spannung, die im Betrieb zum Treiben eines Stroms über den Signalkontakt erforderlich ist, insbesondere anhand des Überschreitens vorgegebener oder vorgebbarer Schwellwerte für die sich ergebende Spannung, der Status des an den Signalkontakt angeschlossenen Sensors erkennbar ist. Die Erkennung von High-Pegel und Low-Pegel (entsprechend aktiviertem bzw. nicht aktiviertem Eingangskanal/Sensor) erfolgt dabei vorteilhaft wie bei bisherigen Eingabebaugruppen anhand der Spannungshöhe bei konstantem Strom über den Signalkontakt. Damit ist vorteilhaft auch erreicht, dass für die Anwender der Anschluss von Prozessperipherie an die Geräte unverändert erfolgt, wobei der jeweilige Sensor insbesondere in unveränderter Weise (Versorgungs- und Signalkontakt) angeschlossen wird. In Abhängigkeit vom mittels der Verarbeitungsfunktionalität des Ausspeisungsmittels erkennbaren Status des Sensors wird ein Auswertezweig angesteuert, der zum Transfer des erkannten Status des Sensors an eine Verarbeitungseinheit vorgesehen ist. Dabei ist die Verwendung eines Auswertezweiges komplementär zu einer Lösung, bei der die Verarbeitungsfunktionalität Speichermittel umfasst, aus denen der erkannte Status des angeschlossenen Sensors direkt ablesbar ist. Mit dem Auswertezweig erfolgt der Statustransfer noch auf der Ebene "primärer elektrischer Größen", also durch Stromfluss und nicht bereits auf Ebene digitaler Daten zur Kodierung des logischen Status des Digitaleingangs. Zur galvanischen Trennung umfasst der Auswertezweig bevorzugt einen Optokoppler. Des Weiteren kann gemäß einer vorteilhaften Ausführungsform vorgesehen sein, dass der Auswertezweig ein Anzeigeelement. z.B. eine LED, umfasst, mit dem der erkannte Status des Sensors, also der interne logische Status des Digitaleingangs angezeigt wird. Gemäß einer weiteren bevorzugten Ausführungsform ist vorgesehen, dass die Peripheriebaugruppe als Versorgungskontakt einen ersten und einen zweiten Versorgungskontakt umfasst, wobei der erste Versorgungskontakt zur Versorgung der Peripheriebaugruppe mit elektrischer Energie vorgesehen ist, wobei der zweite Versorgungskontakt zur Ausspeisung elektrischer Energie durch das oder die Ausspeisungsmittel und zum Anschluss des Sensors vorgesehen ist und wobei über den Signalkontakt einspeisbare elektrische Energie über den zweiten Versorgungskontakt ausspeisbar ist. Am zweiten Versorgungskontakt ist dann eine Geberversorgung abgreifbar, wobei die Begriffe Geber und Sensor synonym zu verstehen sind. Mit der aus der EP 1 770 456 B1 bekannten Lösung wird eine Verlustleistungsreduktion in der gesamten Baugruppe erreicht, wobei der von der Baugruppe an den Sensor ausgegebene Strom konstant ist. Durch die komplexen Komponenten (Schaltregler) ergibt sich einerseits eine Kostenerhöhung und andererseits ist ein zusätzlicher Speisepunkt im Aufbau erforderlich. Weiterhin können hohe EMI Emissionen auftreten, die über das ungeschirmte Kabel am Signalkontakt abgestrahlt werden.

Eine zur EP 1 770 456 B1 inverse Lösung ist aus der EP 1 770 457 B1 bekannt. Insbesondere ist die elektrische Quelle zur Abgabe eines elektrischen Stroms über den Signalkontakt zur Versorgung eines an den Signalkontakt und den Massekontakt anschließbaren Sensors vorgesehen. Hier liegt die Besonderheit im Anschluss des Sensors an den Signal- und den Massekontakt, während bei den bisher bekannten Baugruppen stets ein Anschluss externer Sensorik an den Signal- und einen Versorgungskontakt erfolgt. Ferner ist die baugruppenintern vorgesehene elektrische Quelle als getaktete Konstantstromquelle ausgeführt. Dies ermöglicht eine nochmalige weitere Reduktion der baugruppenseitig anfallenden Verlustleistung, da die getaktete Konstantstromquelle sich durch einen höheren Wirkungsgrad als andere elektrische Quellen auszeichnet und aufgrund des erhöhten Wirkungsgrades die Verlustleistung, die an der getakteten Konstantstromquelle anfällt, entsprechend reduziert ist. Reduzierte Verlustleistung an der getakteten Konstantstromquelle und damit also reduzierte Verlustleistung innerhalb der Peripheriebaugruppe geht wiederum mit den Vorteilen hinsichtlich einer erreichbareren verkleinerten Bauform oder bei im Wesentlichen gleicher Bauform einer erreichbaren hohem Kanalanzahl einher. Schließlich umfasst die elektrische Quelle, insbesondere in ihrer Ausführung als getaktete Konstantstromquelle, Verarbeitungsfunktionalität, derart, dass anhand einer Spannung, die im Betrieb zum Treiben eines Stroms über den Signalkontakt erforderlich ist, der Status des an dem Signalkontakt angeschlossenen Sensors erkennbar ist. Im Einzelnen ergeben sich dabei (im Beispiel eines Schalters als einfachste Form eines Sensors) Verhältnisse, wonach bei geöffnetem Schalter eine höhere Spannung zum Treiben des Stroms über den Signalkontakt erforderlich ist, während bei geschlossenem Schalter, also näherungsweise einem Kurzschluss zwischen Massekontakt und Signalkontakt, nur eine geringe Spannung zum Treiben des gleichen Konstantstroms erforderlich ist. Die jeweils erforderliche oder die jeweils von der getakteten Konstantstromquelle zum Aufrechterhalten des Konstantstroms erzeugte Spannung ist mittels einer der elektrischen Quelle zugeordneten Verarbeitungsfunktionalität erkennbar. Durch das Erkennen der jeweiligen Spannung kann unmittelbar auf den Status des Sensors, also z.B. "Schalter geschlossen" oder "Schalter offen" geschlossen werden. Bei der aus der EP 1 770 457 B1 bekannten Lösung wird der Sensor "unkonventionell" zwischen Eingang und VSS angeschlossen. Statt einer Stromsenke - wie bei der Lösung nach der EP 1 770 456 B1 - wird eine Stromquelle benutzt. Dabei kann die Stromquelle innerhalb der Baugruppe wie jede andere Stromversorgung realisiert werden, insbesondere als Schaltregler ähnlich wie Schaltregler zur Spannungsversorgung. Mit der aus der EP 1 770 457 B1 bekannten Lösung wird eine Verlustleistungsreduktion in der gesamten Baugruppe erreicht, wobei der von der Baugruppe an den Sensor ausgegebene Strom konstant ist. Durch die komplexen Komponenten (Schaltregler) ergibt sich einerseits eine Kostenerhöhung und andererseits ist eine unkonventionelle Anschaltung des Sensors erforderlich. Weiterhin können hohe EMI Emissionen auftreten, die über das ungeschirmte Kabel am Signalkontakt abgestrahlt werden.

Bei den aus der EP 1 770 456 B1 oder der EP 1 770 457 B1 bekannten Lösung wird das grundsätzliche Problem, dass Digitaleingänge Verlustleistung erzeugen, dadurch gelöst, dass die Stromaufnahme soweit reduziert wird, wie es die betreffende Norm zulässt (EN 61131-2). Eine reduzierte Stromaufnahme hat aber wiederum zur Folge, dass bei diesem reduzierten Strom eventuelle vorhandene Leitungskapazitäten nur langsam entladen werden. Die Leitungskapazitäten entstehen aus den zwischen einer Peripheriebaugruppe und dem Sensor geführten Anschlussleitungen. Mit dem reduzierten Entladen der Leitungskapazitäten ergibt sich das Problem, dass damit eine maximale Schalt- bzw. Signalfrequenz eingeschränkt ist. Um einerseits eine baugruppenseitig anfallende Verlustleistung zu reduzieren, andererseits dennoch mögliche vorhandene Leitungskapazitäten schnell genug entladen zu können, wird in der EP 3 333 656 A1 eine Schaltungsanordnung für einen Digitaleingang einer Peripheriebaugruppe vorgeschlagen, wobei diese Schaltungsanordnung einen als Digitaleingang fungierenden Eingangsanschluss, einen Masseanschluss (wobei zwischen dem Eingangsanschluss und dem Masseanschluss ein Halbleiterschaltmittel zur Strombegrenzung eines Eingangsstromes angeordnet ist) und eine Referenzspannungsquelle aufweist, welche zur Ansteuerung des Halbleiterschaltmittels mit einem Steuereingang des Halbleiterschaltmittels verbunden ist. Im Einzelnen ist ein Regelungsmittel vorhanden, welches abhängig von einer Eingangsspannung am Eingangsanschluss die Referenzspannungsquelle derart regelt, dass das Hauptleiterschaltmittel bei einem ersten Spannungswert für die Eingangsspannung den Eingangsstrom auf einen ersten Eingangsstrom einstellt und bei einem zweiten Spannungswert für die Eingangsspannung den Eingangsstrom auf einen zweiten Eingangsstrom einstellt. Dabei ist der erste Spannungswert größer als der zweite Spannungswert und aufgrund des Regelungsmittels ist dadurch der erste Eingangsstrom kleiner als der zweite Eingangsstrom. Dadurch wird ein Digitaleingang realisiert, der bei einer großen Eingangsspannung (30 V) möglichst wenig Strom "zieht" (2mA), damit die entstehende Verlustleistung gering bleibt und bei geringer Spannung (11 V) mehr Strom "zieht" (5,4 mA), damit die vorhandene Leitungskapazität rasch entladen wird und somit Signale mit hohen Schaltfrequenzen erfasst werden können. Das Halbleiterschaltmittel ist als ein erster Transistor mit einem Kollektor, einem Emitter und einer Basis ausgestaltet und die Basis ist mit dem Steuereingang verbunden. Das Regelungsmittel weist einen zweiten Transistor mit einem Kollektor, einem Emitter und einer Basis auf, die Basis des zweiten Transistors ist über einen Spannungsteiler mit dem Kollektor des ersten Transistors verbunden und der Kollektor des zweiten Transistors ist mit dem Steuereingang verbunden. Weiterhin ist es vorteilhaft, wenn die Referenzspannungsquelle durch einen weiteren Spannungsteiler gebildet ist. Sobald der zweite Transistor leitend wird, wird zunehmend eine Parallelschaltung eines Widerstands des Spannungsteilers und des Eingangswiderstands erreicht. Damit wird die Referenzspannung der Referenzspannungsquelle $V_{Ref}$ reduziert. Die Reduzierung der Referenzspannung der Referenzspannungsquelle $V_{Ref}$ führt dazu, dass - wegen der Gegenkopplung mit dem Emitterwiderstand des ersten Transistors - auch der Kollektorstrom durch den ersten Transistor reduziert wird. Damit wird der Eingangsstrom $I_{in}$ automatisch begrenzt. Bei einer geringen Eingangsspannung $V_{in}$ wird über den Eingangsanschluss ein hoher Strom aufgenommen. Bei einer hohen Eingangsspannung $V_{in}$ wird ein geringer Strom aufgenommen. Wie die Signalverläufe von Strom und Spannung gemäß der Schaltungsanordnung zeigen, steigt die Eingangsspannung $V_{in}$ von 0 V auf 30 V und fällt dann wieder von 30 V auf 0 V. Der Eingangsstrom $I_{in}$ steigt mit steigender Eingangsspannung $V_{in}$ zunächst stark an (bis etwa 5,4 mA) und wird dann mit weiter steigender Eingangsspannung $V_{in}$ auf einen ersten Eingangsstrom $I_{in1}$ (etwa 2 mA) zurückgeregelt. Bei einer Eingangsspannung $V_{in}$ von ca. 30 V erhält man damit wieder eine Verlustleistung von etwa 60 mW. Fällt die Eingangsspannung $V_{in}$ wieder von ihrem Maximalwert 30 V, so wird der Strom wieder hochgeregelt, wobei man sagen kann, zu dem ersten Spannungswert U1 gehört ein erster Eingangsstrom $I_{in}$ und zu dem zweiten Spannungswert U2 gehört ein zweiter Eingangsstrom $I_{in2}$. Dabei stellt der erste Transistor Q1 bei einem ersten Spannungswert U1 für die Eingangsspannung $V_{in}$ den Eingangsstrom $I_{in}$ auf einen ersten Eingangsstrom $I_{in1}$ ein und bei einem zweiten Spannungswert U2 für die Eingangsspannung $V_{in}$ den Eingangsstrom $I_{in}$ auf einen zweiten Eingangsstrom $I_{in2}$ ein, wobei der erste Spannungswert U1 größer ist als der zweite Spannungswert U2 und aufgrund des Regelungsmittels dadurch der erste Eingangsstrom $I_{in1}$ kleiner ist als der zweite Eingangsstrom $I_{in2}$. Die Pegelerkennung (High-Pegel/Low-Pegel) wird in der Regel mit einem Komparator realisiert, der die Eingangsspannung $V_{in}$ erfasst. Bei der Lösung gemäß der EP 3 333 656 A1 wird der Spielraum der in der IEC6113-2 beschriebenen Stromsenken-Kennlinie ausgenutzt, um einen vorteilhaften Kompromiss zwischen Schaltzeit und Verlustleistungserhöhung zu finden. Die Stromsenke folgt einer Kennlinie, die bei steigender Spannung fallenden Strom hat. Die Kennlinie bewegt sich im von IEC61131-2 gegebenen Korridor, i.e. sie erfüllt die Norm für sich allein. Die Entladung einer Kapazität wird dadurch im unteren Spannungsbereich beschleunigt. Der Verlustleistungsanstieg ist geringer als bei einem erhöhten Konstantstrom, da der höhere Strom nur bei geringerer Spannung verwendet wird. Die Realisierung der gewünschten Kennlinie erfolgt durch eine konkret beschriebene diskrete Schaltung mit zwei Transistoren und Widerständen, wodurch das Ziel: Minimierung der Verlustleistungserhöhung (die durch die Erhöhung der Schaltgeschwindigkeit einhergeht) erreicht wird. Andererseits ist die Gesamt-Verlustleistung (auf Baugruppenebene) höher als beim Stand der Technik (Konstantstromquelle).

Eine weitere digitale Eingangsschaltung, welche die Norm (EN 61131-2) erfüllt, ist aus der US 9,294,063 B1 bekannt. Die Eingangsschaltung weist einen Eingangswiderstand und einen Eingangskondensator, einen Strombegrenzer, einen elektronischen Schalter und einen logischen Pegelumsetzer auf. Der Strombegrenzer und der elektronische Schalter umfassen eine Reihenschaltung, die direkt oder indirekt zwischen einer Eingangsspannung $V_i$ und Masse geschaltet ist. Ein Sensor koppelt den Eingangswiderstand an die Feldspannungsversorgung $V_s$ (z.B. 24 V Gleichspannung). Der Strombegrenzer, der elektronische Schalter und der Logikpegelumsetzer können in einer Ausführungsform einen Teil einer integrierten Schaltung bilden oder als diskrete Komponenten oder als eine Kombination von diskreten Komponenten und einer oder mehreren integrierten Schaltungen aufgebaut werden. In einer Ausführungsform mit mehreren Kanälen können andere Komponenten der digitalen Eingangsschaltung, wie beispielsweise der Eingangswiderstand und der Eingangskondensator, extern bereitgestellt werden, z.B. auf einer Leiterplatte der digitalen Eingangsschaltung. In einer Ausführungsform enthält der logische Pegelumsetzer einen Spannungs- / StromKomparator, ein Tiefpassfilter, einen Taktgeber, welcher ein Taktsignal erzeugt, und einen Inverter. Ein Eingang des Komparators ist mit dem Eingangswiderstand und dem Strombegrenzer verbunden, d.h. in dieser Ausführungsform ist der Strombegrenzer direkt mit der Eingangsspannung $V_i$ verbunden. Anderen Eingängen des Komparators werden eine Schwellenreferenzspannung und ein Schwellenreferenzstrom zugeführt. Das Tiefpassfilter entfernt zur Entprellung bestimmte Transienten, die in dem Eingangssignal $V_i$ vorhanden sein können. Hierzu kann das Tiefpassfilter als ein digitales Tiefpassfilter ausgestaltet werden, welches das Taktsignal vom Taktgeber erhält. Der Taktgeber kann ein RC-Oszillator mit einer Nennfrequenz von etwa 125 kHz sein, obwohl andere Frequenzen auch in Abhängigkeit von der Implementierung des Tiefpassfilters und den Systemanforderungen geeignet sind. Ferner kann das Tiefpassfilter mit drei bistabilen Multivibratoren und einem UND-Gatter aufgebaut werden. Am Ausgang des Inverters wird ein Schaltersteuersignal erzeugt, das den elektronischen Schalter steuert. Durch Ausschalten des Eingangsstroms $i_L$, wenn das Signal nicht verarbeitet wird, nimmt der Energieverbrauch ab und eine Energieeinsparung von etwa 50% oder mehr kann erzielt werden. Die galvanische Isolierung kann auch durch einen externen Optokoppler, einen externen digitalen Isolator oder einen integrierten digitalen Isolator bereitgestellt werden. In einer weiteren Ausführungsform enthält der logische Pegelumsetzer einen Spannungskomparator, einen Stromkomparator, einen Niedrigstrombegrenzer, einen monostabilen Multivibrator und ein Latch. Die Eingänge des Spannungskomparators und des Stromkomparators sind mit dem Eingangswiderstand verbunden. In diesem Beispiel fließt der Strom $I_T = I_L + I_{lo}$ durch den Stromkomparator. Daher ist in diesem Beispiel der Strombegrenzer über den Stromkomparator anstatt direkt mit der Eingangsspannung $V_i$ verbunden. Eine Referenzspannung $V_{TH}$ wird an einen Eingang des Spannungskomparators angelegt, und ein Referenzstrom $i_{TH}$ fließt durch den Stromkomparator. Wenn während der Zeitspanne $t_{os}$, in welcher der einzige Impuls (one shot) aktiviert ist, der Wert des durch den Stromkomparator erfassten Stroms den Schwellenstrom $I_{th}$ überschreitet, wird das Latch auf logisch "high" umgeschaltet, was anzeigt, dass eine logische "1" vom Sensor erkannt wurde. Wenn der Strom den Schwellenstrom $I_{th}$ nicht überschreitet, wird das Latch auf logisch "low" umgeschaltet, wodurch angezeigt wird, dass der Strom vom Sensor unter dem erforderlichen Schwellenwert $I_{th}$ war und das Signal des Sensors eine logische "0" ist. Auf diese Weise wird nur während der Zeitspanne $t_{os}$ Strom gezogen und Leistung nur während der gesamten Zeitdauer abgeführt, und nicht während der gesamten Zeit, in der sich der Sensor im Ein-Zustand $T_{on}$ befindet. Dies reduziert die durchschnittliche Verlustleistung um einen Faktor von $t_{os} / T_{on}$. Die Zeitspanne $t_{os}$ ist vorzugsweise so lang ausgebildet, dass eine ausreichend lange Einschwingzeit zum Laden / Entladen von mit dem Sensor verbundenen parasitären und / oder beabsichtigten Kapazitäten, seiner Verdrahtung und der Eingangserfassungsschaltung ermöglicht wird.

Eine ähnliche digitale Eingangsschaltung, welche die Norm (EN 61131-2) erfüllt, ist aus der US 9,608,635 B1 bekannt. Die Eingangsschaltung weist wiederum eine Reihenschaltung aus einem Strombegrenzer und einem zwischen einen Signaleingang und Masse geschalteten Schalter auf, wobei der Schalter einen Schaltersteuereingang aufweist. Weiterhin ist ein logischer Pegelumsetzer vorgesehen, der einen Spannungskomparator und ein Tiefpassfilter enthält. Der logische Pegelumsetzer ist mit dem Signaleingang verbunden und weist einen Schaltersteuerausgang auf, der mit dem Schaltersteuereingang gekoppelt ist. Mit dem Tiefpassfilter ist ein Takt/Oszillator verbunden. Weiterhin weist die Eingangsschaltung einen N-Zähler auf, welcher den Takt mit dem Schaltersteuereingang koppelt. Ferner weist die Eingangsschaltung einen Signalausgang auf, wobei eine maximale Amplitude am Signaleingang größer ist als eine maximale Amplitude am Signalausgang. Der Spannungskomparator weist einen mit dem Signaleingang gekoppelten Eingang und einen durch den Tiefpassfilter mit dem Signalausgang gekoppelten Ausgang auf. Um die Verlustleistung zu verringern, wird beim Gegenstand der US 9,608,635 B1 ein Duty-Cycling Verfahren verwendet, d.h. der Strom zyklisch abgeschaltet bzw. reduziert. Die in der Norm geforderten Stromstärken werden bei Aktivierung der Stromsparfunktion nicht dauerhaft eingehalten, d.h. die Norm (EN 61131-2) für digitale Eingänge wird nicht mehr erfüllt. Einige Sensoren, die nicht nur einfache Schalter sind, sondern sich aus dem Strom versorgen oder eine Kapazität haben, können damit nicht mehr funktionieren. Ferner erfordern IO-Link Eingänge (IEC-61131-9) ebenfalls zwingend einen kontinuierlichen Strom, die Bitzeiten erlauben kein Duty Cycling.

Wie die vorstehende Würdigung des Standes der Technik aufzeigt, sind je nach Anwendungsfall unterschiedlich ausgestaltete digitale

Eingangsmodule/Eingangsschaltungen bekannt. Schaltregler oder diskretere Lösungen sind teuer, da zu viele externe Bauteile benötigt werden. Eine Vollintegrierung der Stromsenken ist zwar möglich, stellt aber hohe Anforderungen an das thermische Budget des Chips und reduziert die Anzahl der Kanäle pro Chip.

In der Praxis wird ab 8 Kanälen pro Chip eine Vollintegrierung schwierig. Lösungen, die 8 Kanäle pro Chip vollständig implementieren, müssen daher Beschränkungen hinnehmen, beispielsweise US 9,294,063 B1 oder US 9,608,635 B1. Diese Beschränkungen erlauben kein vollständiges Einhalten der Norm EC61131-2 Typ 3, so dass in der Praxis eine Implementierung von IO-Link konformen Eingängen sich schwierig gestaltet, wobei diese für den jeweiligen speziellen Anwendungsfall, insbesondere auf dem Gebiet der Automatisierungstechnik ausgestaltet sind. Ein IO-Link ist eine intelligente Sensor-/Aktorschnittstelle, welche als internationaler offener Standard in der Norm IEC61131-9 genormt ist. In der Regel bildet die IO-Link-Schnittstelle die gesamte Ein-/Ausgangsstruktur aus, das heißt außer der IO-Link-Schnittstelle brauchen keine weiteren Ein- oder Ausgänge oder sonstige Schnittstellen vorgesehen sein. Vorteilhaft ist mit der IO-Link-Schnittstelle wenigstens ein Digitaleingang und ein Digitalausgang ausgebildet, über welchen digitalisierte Messwerte in die SPS (Prozessor) eingebbar sind oder über welche generierte Schaltsignale oder Steuersignale zum IO-Link Gerät/device (Sensor als slave) ausgebbar sind. Als IO-Link-Master stehen sowohl Feldbusmodule als auch SPS-Schnittstellenbaugruppen zur Verfügung. IO-Link-Verbindungen sind abwärts kompatibel zu binären Standardsensoren und verwenden durchgängig ungeschirmte drei- oder fünfadrige Standardleitungen. In einem IO-Link-System/Netzwerk bildet generell der IO-Link-Master mit angeschlossenen IO-Link-Slaves Punkt-zu-Punkt Verbindungen aus, so dass die einzelnen IO-Link-Slaves nicht unter Adressen vom Master angesprochen werden müssen, das heißt das IO-Link-System ist kein Feldbus und weist damit einen äußerst einfachen Aufbau auf. Zum Anschluss mehrerer IO-Link-Slaves weist der IO-Link-Master zur Ausbildung der Punkt-zu-Punkt Verbindungen mehrere Ports auf, wobei an jedem Port jeweils ein IO-Link-Slave mit seiner IO-Link-Schnittstelle angeschlossen werden kann. In der Kommunikation mit den IO-Link-Mastern kann die IO-Link-Schnittstelle des IO-Link-Slaves in unterschiedlichen Betriebsarten betrieben werden, so dass die IO-Link-Schnittstelle wahlweise einen spezifischen Digitaleingang oder Digitalausgang ausbildet über welchen digitalisierte Daten ein- oder ausgegeben werden können.

Wesentliche Bestandteile digitaler Eingänge nach IEC61131-2 können in einer integrierten Schaltung (IC) realisiert werden. Möchte man Systeme mit mehreren Eingängen realisieren, kann man mehrere Kanäle in einem IC bündeln, um die Anzahl der IC im Gesamtsystem zu reduzieren und somit Kosten zu optimieren. Der in IEC61131-2 geforderte Mindeststrom erzeugt jedoch eine Verlustleistung, die üblicherweise im IC entsteht. Dadurch wird die Anzahl der Kanäle pro IC begrenzt, da die Verlustleistung pro IC begrenzt ist. Somit ergibt sich eine Grenze für weitere Kostenreduktion.

Mit der Einführung von Industrie 4.0 kommt der Erfassung von Sensordaten eine wachsende Bedeutung zu. In der Regel werden - wie die vorstehende Würdigung des Standes der Technik aufzeigt - Sensoren (oder allgemein IO-Link Geräte) in der Anlage bzw. Maschine an dezentrale Ein-/Ausgangskomponenten angeschlossen, welche diese mit der Steuerung oder direkt mit einer Cloud-Applikation über ein standardisiertes Netzwerk verbinden. Dabei werden - je höher der Automatisierungsgrad ist - mehr Sensoren und Aktoren eingesetzt. Insbesondere müssen für die Kommunikation die Feldbussysteme, wie z. B. PROFIBUS, Interbus, AS-Interface, Echtzeit-Ethernet-Systeme (wie beispielsweise PROFINET) und drahtlose Übertragungssysteme, entsprechende Echtzeitanforderungen erfüllen. Der Ein-/Ausgabe (input/output), d.h. der Schnittstelle, über welche die Kommunikationsverbindungen betrieben und die über Daten-, Steuer- und Adressbusse angeschlossenen Geräte gesteuert werden (Eingabe, beispielsweise Sensoren für Temperatur, Drehzahl, Druck usw. bzw. Ausgabe, beispielsweise zur Parametrierung von Aktuatoren der Regel- und Messtechnik und Überwachung einzelner oder ganzer Anlagenfunktionen) kommt dabei erhöhte Bedeutung zu.

Der Erfindung liegt die Aufgabe zugrunde eine Baugruppe mit mindestens einer Schnittstellenschaltung für den Anschluss mehrerer Signalquellen derart auszugestalten, dass eine Verlustleistungsreduktion an der kostenintensiven integrierten Schaltung innerhalb der Baugruppe ermöglicht wird, um die Anzahl der Kanäle pro integrierter Schaltung zu erhöhen und somit die Kosten pro Kanal zu senken.

Diese Aufgabe wird, nach Patentanspruch 1, mit einer Baugruppe mit mindestens einer Schnittstellenschaltung für den Anschluss einer Signalquelle, welche innerhalb einer integrierten Schaltung und außerhalb der integrierten Schaltung angeordnete Bauelemente aufweist, gelöst, wobei die Schnittstellenschaltung derart ausgestaltet ist, dass:

- innerhalb der integrierten Schaltung befindet sich eine spannungsabhängig geregelte Stromquelle oder Stromsenke,
- außerhalb der integrierten Schaltung befindet sich ein Bauelement und
- das Bauelement ist zur Stromquelle oder Stromsenke parallel geschaltet, wobei die Stromquelle oder Stromsenke spannungsabhängig so geregelt wird, dass der Summenstrom aus Strom der Stromquelle oder Stromsenke und Strom aus dem passiven Bauelement eine geringere Spannungsabhängigkeit aufweist als der Strom vom passiven Bauelement allein, derart, dass eine Umverteilung der Verlustleistung innerhalb der Schnittstellenschaltung erfolgt.

Die erfindungsgemäße Baugruppe/Schnittstellenschaltung ist universell einsetzbar und ermöglicht eine Umverteilung der Verlustleistung innerhalb der Baugruppe von der kostenintensiven Komponente (IC) zu kostengünstigen passiven Komponenten: Dadurch können einerseits die Kosten der Baugruppe reduziert werden und andererseits wird durch die im Betrieb robuste passive Komponente eine erhöhte Lebensdauer der Baugruppe, insbesondere der integrierten Schaltung, ermöglicht. Dabei geht die Gesamt-Verlustleistung der Baugruppe nicht über den Stand der Technik hinaus, der Eingang verhält sich normgerecht (IEC6113-2) und ist Spannungsbasiert auswertbar. Die kostengünstig realisierte passive Komponente hat eine steigende U/I Kennlinie, die so ausgelegt werden kann, dass sie bei maximaler Spannung den in der Norm geforderten Minimalstrom liefert, damit die Verlustleistung in der Gesamt-Baugruppe nicht erhöht wird. Um in Summe den in der Norm geforderten konstanten Strom zu erreichen, ist erfindungsgemäß die Kennlinie der parallel geschalteten kostenintensiven Komponente so ausgelegt, dass sie den "fehlenden" Strom ergänzt. Es zeigt sich, dass bei dieser Aufteilung ein erheblicher Teil der Verlustleistung an der passiven Komponente abfällt.

In Ausgestaltung der Erfindung ist, gemäß Patentanspruch 2, das Bauelement als passives Bauelement der Schnittstellenschaltung ausgestaltet und besteht aus einer oder mehreren passiven elektronischen Komponenten. Weiterhin ist, gemäß Patentanspruch 4, das passive Bauelement ein Widerstand.

Dessen Widerstandswert ist im Idealfall so gewählt, dass er bei maximaler Spannung den minimal in der IEC Norm geforderten Strom führt. Bei kleiner Spannung wird der Strom an der passiven Komponente kleiner als der geforderte minimale Gesamtstrom. Dieser "fehlende" Strom wird durch die geregelte Stromsenke innerhalb des IC ergänzt.

Diese Ausgestaltung der Erfindung weist den Vorteil auf, dass der Widerstand bei hoher Supply-Spannung die komplette Verlustleistung übernimmt, aber auch nicht mehr als minimal gefordert. Versucht man stattdessen, nur einen (kleineren) Widerstand als "Stromsenke" zu verwenden, könnte Dessen Kennlinie könnte zwar gerade so die IEC Norm erfüllen, wäre dann aber energetisch wesentlich ungünstiger für das Gesamtsystem:

Typ 1 erfordert mind. 0,5mA bei 5V, also würde ein Widerstand bei 30V 3mA verbrennen, eine Stromsenke nur 2mA.

Typ 2 erfordert mind. 2mA bei 5V, also würde ein Widerstand bei 30V 12mA verbrennen, eine Stromsenke nur 6mA.

Typ 3 erfordert mind. 1.5 mA bei 5V, also würde ein Widerstand bei 30V 9mA verbrennen, eine Stromsenke nur 2mA. Für Typ 3 wäre ein reiner Widerstand also besonders ungeeignet.

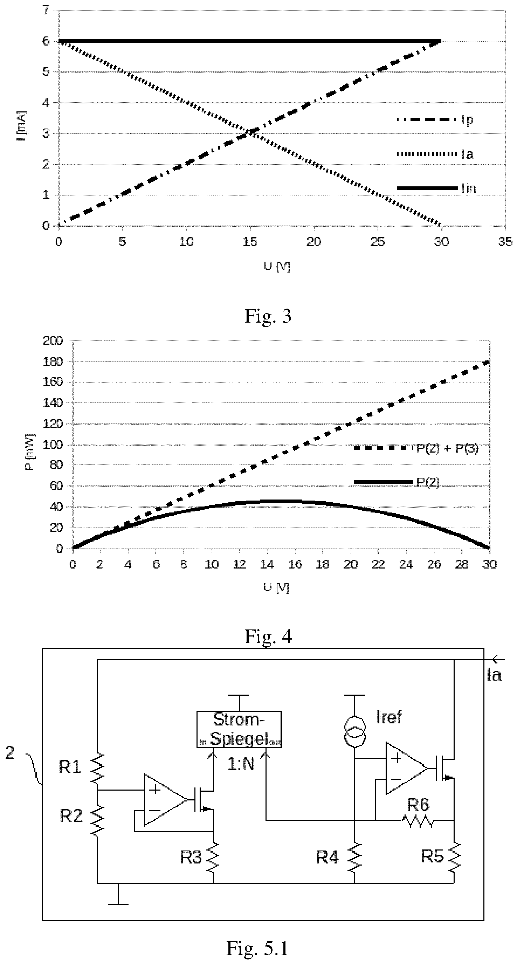

Erfindungsgemäß werden Widerstand und eine speziell geregelte Stromquelle parallel betrieben. Der Widerstand ist größer als bisher beschrieben, und zwar so gewählt, dass an ihm - bei einer Spannung von 30V - der minimal geforderte Strom fließt. Die Stromquelle wird erfindungsgemäß so geregelt, dass sie letztendlich den fehlenden Strom bei niedrigeren Spannungen ergänzt. Dieser "fehlende" Strom ist Spannungsabhängig steigend mit fallender Spannung und wird von der spannungsabhängig geregelten Stromsenke innerhalb des IC passend erzeugt, sodass der Gesamtstrom bei jeder Spannung dem minimal geforderten entspricht. Bei idealer Regelung der Stromquelle oder -Senke und idealem Widerstandswert und wenn ein über die Spannung konstanter Minimalstrom gefordert ist ergibt sich eine Reduktion der Verlustleistung innerhalb des IC um Faktor 4 gegenüber der Gesamt-Verlustleistung, wie in Fig. 4 dargestellt.

Aufgrund der großen Verlustleistungsreduktionergibt sich eine erhebliche Verlustleistungsreduktion selbst dann, wenn die verwendeten Komponenten hohe Ungenauigkeiten aufweisen, d.h. der Widerstand eine große Toleranz aufweist oder der Strom innerhalb des IC nicht ideal geregelt wird und deshalb als Schwankungsreserve etwas mehr als der minimal geforderte Strom geliefert werden muss.

In Weiterbildung der Erfindung wird, gemäß Patentanspruch 4, der Strom der Stromquelle oder Stromsenke durch Messen der an der Schnittstellenschaltung anliegenden Spannung in Stufen umgestellt.

Diese Weiterbildung der Erfindung weist den Vorteil auf, dass auf einfache Art und Weise eine stufenförmige Kennlinie durch Umschalten erzeugt werden kann.

Insbesondere wird, gemäß Patentanspruch 6, mittels linearer Schaltungstechnik der Schnittstellenschaltung eine U/I- Kennlinie der jeweiligen Stromquelle oder Stromsenke derart erzeugt, dass deren U/I- Kennlinie einer Konstantstromquelle mit parallelem, negativem Widerstand entspricht.

Bei allen beschriebenen vorteilhaften Ausgestaltungen der Erfindung wird eine optimierte Verteilung der Verlustleistung zwischen Komponenten (z.B. integrierte Schaltung IC und passive Komponente (R)) innerhalb der Baugruppe erreicht und der von der Baugruppe an den Sensor ausgegebene Strom ist über die Spannung hinweg konstanter als wenn man diesen Strom allein durch eine passive Komponente erzeugen würde. Die Verlustleistung der gesamten Baugruppe ist geringer als wenn man nur einen Widerstand als Stromsenke oder -Quelle verwendet. Die Verlustleistung innerhalb des IC ist geringer als würde man eine Konstantstromsenke oder -Quelle ohne externe Komponente verwenden.

Weitere Vorteile und Einzelheiten lassen sich der nachfolgenden Beschreibung von bevorzugten Ausführungsformen der Erfindung unter Bezugnahme auf die Zeichnungen entnehmen. In der Zeichnung zeigt:

Fig. 1        das Blockschaltbild der erfindungsgemäßen Baugruppe,
Fig. 2        im Detail einen Kanal der Baugruppe nach Fig. 1,
Fig. 3        die Strom-/Spannungskennlinie für integrierte Schaltung IC und passive Komponente sowie Gesamtstrom eines Kanals,

Fig. 4    die On-Chip-Verlustleistung in Abhängigkeit von der Spannung,

Fig. 5.1.    eine Ausgestaltung einer geregelten Stromquelle in Form einer Operationsverstärkerschaltung OPV (Beispiel 1),

Fig. 5.2    eine Ausgestaltung einer geregelten Stromquelle in Form einer Operationsverstärkerschaltung OPV (Beispiel 2),

Fig. 6    eine Ausgestaltung einer geregelten Stromquelle mit stufenweiser U/I-Kennlinie und

Fig. 7    Darstellung der geregelten Stromquelle als Ersatzschaltbild mittels Strom- oder Spannungsquelle mit negativem Innenwiderstand und

Fig. 8    Darstellung der geregelten Stromquelle mit separatem Stromquellen- und Steuerungsblock.

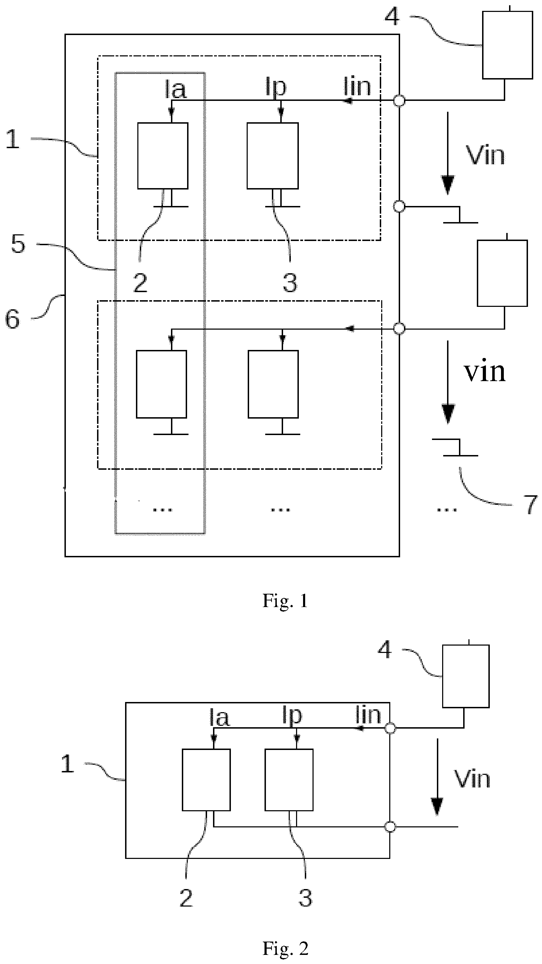

Das Blockschaltbild einer erfindungsgemäßen Baugruppe 6 ist in Fig. 1 dargestellt. Für den Anschluss mehrerer Signalquellen 4 sind innerhalb der Baugruppe 6 entsprechend viele Schnittstellenschaltungen 1 platziert. Eine solche Schnittstellenschaltung 1 weist eine geregelte Stromsenke oder -Quellen 2 innerhalb der integrierten Schaltung 5 und eine passive Komponente 3 außerhalb der integrierten Schaltung auf. Die Komponenten 3 mehrerer Schnittstellenschaltungen 1 befinden sich innerhalb einer gemeinsamen integrierten Schaltung 5. Die Komponenten 2 und 3 einer Schnittstellenschaltung 1 sind parallel mit der Signalquelle 4 verbunden, sodass ein Gesamtstrom Iin (siehe Fig. 3) beider Komponenten an der Signalquelle auftritt. Komponente 2 ist eine geregelte Stromquelle-oder Senke, die in Abhängigkeit der an ihr abfallenden Spannung Vin so geregelt wird, dass der Summenstrom (Iin = Ia + Ip) aus der Stromquelle oder Stromsenke 2 und aus dem dazu parallel geschalteten Bauelement 3 eine geringere Spannungsabhängigkeit aufweist als der vom Bauelement 3 allein.

Erfindungsgemäß ist das passive Bauelement 3 ein Widerstand, dessen Widerstandswert so gewählt ist, dass bei maximal geforderter Spannung der minimal geforderte Strom fließt. Die geregelte Stromquelle oder -Senke 2 wird so geregelt, dass ihre U/I- Kennlinie fallend ist.

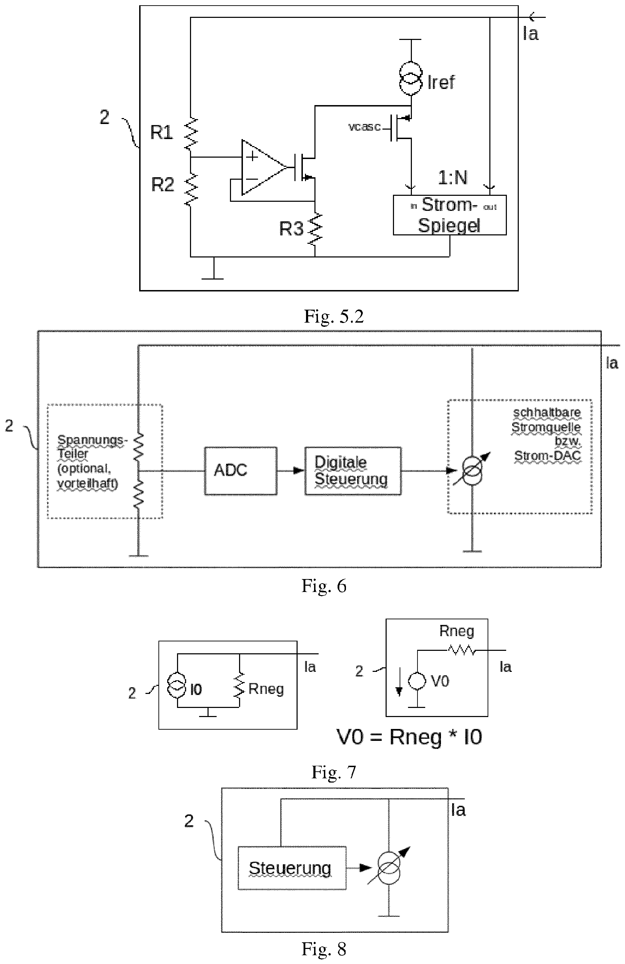

Mögliche bevorzugte Ausgestaltungen, welche lineare Schaltungstechnik zum Erzeugen der Kennlinie verwenden, sind in Fig. 5.1 und Fig. 5.2 dargestellt. Ein Stromspiegel ist eine in der integrierten Schaltungstechnik übliche einfach zu realisierende Schaltung, welche in den Fig. 5.1 und 5.2 einen Eingangsstrom "in" entgegennimmt und einen Ausgangsstrom "out" erzeugt, wobei der Ausgangsstrom dem N-Fachen Eingangsstrom entspricht. Die Stromrichtungen sind an dieser Stelle durch Pfeile gekennzeichnet. Ein einfacher MOSFET Stromspiegel ist für die Ausgestaltung ausreichend. Die in Fig. 5.1 und 5.2 gezeigten idealen Stromquellen "iref" sind Referenzströme, mit idealerweise konstantem Strom. Sie können mittels IC Schaltungstechnik (z.B. Bandgap Referenz) hinreichend genau realisiert werden. Im Rahmen der Erfindung kann auch ein Mikroprozessor benutzt werden, welcher unter Verwendung von gespeicherten Referenzwerten den Strom der Stromquelle oder Stromsenke 2 in Abhängigkeit der gemessenen sich ändernder Eingangsspannung der mindestens einen Schnittstellenschaltung 1 regelt.

Allgemein kann mittels linearer Schaltungstechnik eine U/I- Kennlinie der jeweiligen Stromquelle oder Stromsenke 2 derart realisiert werden, dass deren U/I-Kennlinie einer Konstantstromquelle mit parallelem negativem Widerstand entspricht. Ein Ersatzschaltbild für derartige Ausgestaltungen ist in Fig. 7 dargestellt. Die Darstellung ist auch mittels Spannungsquelle und negativem Serienwiderstand möglich.

So kann z.B. die Schaltung gemäß Fig. 5.1 in das Ersatzschaltbild transformiert werden:

$$I0 \approx Iref * N$$

$$Rneg \approx -((R1+R2)/R2) * R3/R2 * 1/N),$$

näherungsweise bei Vout*(R1+R2) << I0, R5 << R4, R5 << R6.

Fig. 5.1 kann folgendermaßen transformiert werden:

$$I0 \approx Iref * R4 / R5$$

$$Rneg \approx -((R1+R2)/R2 * R3/R2 * 1/N * R6/R4),$$

näherungsweise bei Vout*(R1+R2) << 10.

Es sind auch Ausgestaltungen nach Fig. 8 denkbar, in denen eine einstellbare Stromquelle existiert und diese durch einen separaten Steuerungsblock, welcher die anliegende Spannung kennt, derart angesteuert wird, dass die gewünschte tendenziell fallende U/I Kennlinie entsteht. Diese Art der Regelung kann auch in Stufen erfolgen, realisierbar durch Digitaltechnik, wie dies in Fig. 6 gezeigt ist.

Anzumerken ist, dass nicht jede Ausgestaltung in Stromquellen- und Regleranteil separierbar ist und deshalb Fig. 8 keine ganz allgemeine Darstellung der geregelten Stromquelle (2) ist. So sind z.B. in den Ausgestaltungen Fig. 5.1 und Fig. 5.2 diese beiden Anteile ineinander vermischt/miteinander verschmolzen.

Die in Fig. 3 dargestellte Strom-/Spannungskennlinie kann auf verschiedene Art realisiert werden. Wichtig ist, dass die Kennlinie tendenziell fällt. Mögliche Realisierungen für Ia sind:

- OPV-Schaltung (OPV: Operationsverstärker ist ein gleichspannungsgekoppelter elektronischer Verstärker mit einer sehr hohen Verstärkung), die einen virtuellen negativen Widerstand und eine Stromquelle realisiert und somit genau die beschriebene lineare Kennlinie erzeugt (siehe Fig. 7).

- Stufenweises Umschalten einer ansonsten konstanten Stromquelle anhand der Spannung. Dann wird die Kennlinie treppenförmig (siehe Fig. 6 mit ADC (Analog-/Digitalwandler), digitaler Controller (Steuereinrichtung) und Strom-DAC (Digital-/Analog-Wandler)).

Ip entsteht im Idealfall durch einen Widerstand 3. Ein Widerstand ist am kostengünstigsten. Im Rahmen der Erfindung kann man hier auch eine tendenziell steigende U/I Kennlinie realisiert werden (beispielsweise mittels eines Inverters).

Wenn man jetzt die in Fig. 4 dargestellte On-Chip-Verlustleistung P(2) eines Kanals betrachtet, ist diese an beiden Enden der Spannungsskala Null:
Nahe 0V wird zwar viel Strom, aber wenig Spannung geliefert.

Bei maximaler Spannung 30V wird hingegen der Strom zu null.

Dazwischen verläuft die Verlustleistung hyperbolisch, wobei die maximale Verlustleistung bei maximaler Spannung /2 auftritt. An diesem Punkt sind jedoch sowohl Strom als auch Spannung nur halb so groß wie die maximale Verlustleistung einer gegenüber der Spannung konstanten Stromquelle. P(2) + P(3) zeigt einen solchen Verlustleistungsverlauf. Die maximal auftretende On- Chip-Verlustleistung ist erfindungsgemäß somit auf ein Viertel reduziert.

Dadurch wird z.B. eine Implementierung von 16 Kanälen pro Chip möglich, welche die Normen IEC 61131-2 Typ 3 Eingänge (6mA) oder IEC 61131-9 (IO-Link, 5mA) vollständig erfüllt. Die Kosten pro Kanal werden reduziert weil es möglich wird max. 4-Mal mehr Kanäle in einem IC zu bündeln. Über die generierte Kennlinie hinweg ist die Verlustleistung am IC 5 (U*I) immer wesentlich geringer als die Gesamt-Verlustleistung, ideal um Faktor 4. Extern ist nur eine passive Komponente (R) pro Kanal erforderlich. Weiterhin ist von Vorteil, dass kein weiterer Pin am IC 5erforderlich ist und dass ein Standard Anschluss benutzt werden kann. Durch die Parallelschaltung sind beide Anschlüsse der passiven Komponente/Bauelement 3 bereits vorhanden und es werden durch die Erfindung keine weiteren Anschlüsse benötigt. Ferner besteht die in vielen Anwendungen geforderte Möglichkeit der galvanischen Trennung, indem man Gruppen von Schnittstellenschaltungen, die auf einem eigenständigen Potential arbeiten müssen, in getrennten ICs realisiert und die Versorgung und Kommunikationsschnittstelle des IC galvanisch trennt. Weiterhin ist die Möglichkeit, einen Spannungspegel am Sensor zu erkennen nicht behindert und somit ist ein Umgang mit deaktivierten Sensoren bzw. deren Erkennung mittels Spannungspegel-Treshold möglich. Wenn man galvanische Inseln hat, muss man pro Insel einen Chip verbauen, der auf diesem Potential arbeitet. Die Kommunikation zum Gesamtsystem kann dann mit wenigen Leitungen (z.B. SPI) erfolgen, und man muss nur diese Leitungen galvanisch trennen. Das kann kostengünstiger sein, als jeden Signalanschluss einzeln galvanisch zu trennen.

Die Schnittstellenschaltung 1 bei der sich bei ändernder Eingangsspannung der Schnittstelle (gemessene Spannung), der Summenstrom sich weniger stark ändert, als der Strom (Stromänderung) durch das zum jeweiligen Eingang zugehörige passive Bauelement 3 ist vielfältig einsetzbar, insbesondere zur Verwendung der in IEC61131-2 Typ 1/2/3 beschriebenen digitalen Eingängen einer industriellen Steuerungsanlage oder zur Verwendung bei einem in IEC61131-9 beschriebenen Empfänger eines IO-Link Transceivers. Bei einer Realisierung der U/I Kennlinie Komponente (IC) 5 mittels linearer Schaltungstechnik (OPV-Schaltung mit parallelem negativem Widerstand) sind auch andere Möglichkeiten der Implementierung abgedeckt, z.B. separates Messen der Spannung mittels ADC und stellen des Stromes mittels DAC (siehe Fig. 6).

Im Rahmen der Erfindung kann die Operationsverstärkerschaltung 5 (die gesteuerte Quelle) auch als spannungsgesteuerte Spannungsquelle, stromgesteuerte Spannungsquelle oder auch als stromgesteuerte Stromquelle ausgestaltet werden. Weiterhin kann im Rahmen der Erfindung vorgesehen werden den oben genannten Mikroprozessor derart auszugestalten, dass dieser zentral alle Kanäle regelt bzw. zwischen diesen Kanälen abstimmt (mehrere Schnittstellenschaltungen (1) bilden unabhängig voneinander eine Baugruppe (6) und/oder mehrere Schnittstellenschaltungen (1) sind in einer gemeinsamen integrierten Schaltung (5) gebündelt). Die Erfindung ist bislang auch nicht auf die im Patentanspruch 1 definierte Merkmalskombination beschränkt, sondern kann auch durch jede beliebige andere Kombination von bestimmten Merkmalen aller insgesamt offenbarten Einzelmerkmale definiert sein. Dies bedeutet, dass grundsätzlich praktisch jedes Einzelmerkmal des Patentanspruchs 1 weggelassen bzw. durch mindestens ein an anderer Stelle der Anmeldung offenbartes Einzelmerkmal ersetzt werden kann.

Bezugszeichenliste:

1    Schnittstellenschaltung
2    (geregelte) Stromquelle oder Stromsenke
3    (passives) Bauelement(e) (Komponente)
4    Signalquelle (Sensor)
5    integrierte Schaltung
6    Baugruppe
7    gemeinsame Masse

ADC    Analog-/Digitalwandler
DAC    Digital-/Analog-Wandler
in     Eingangsstrom (Stromspiegel)
Ia     Strom durch Stromquelle oder Stromsenke 2
Iin    Summenstrom (Ia + Ip)
I0     Konstantstromquelle
Ip     Strom durch passives Bauelement (Widerstand 3).
Iref   Referenzstrom
OPV    Operationsverstärkerschaltung
P(2)   On-Chip-Verlustleistung (Stromquelle oder Stromsenke 2) eines Kanals
P(3)   Verlustleistung (passive(s) Bauelement(e) 3) eines Kanals
out    Ausgangsstrom (Stromspiegel)
Rneg   negativer Widerstand
Vin    Spannung (an Schnittstellenschaltung 1)

**Patentansprüche**

1.  Baugruppe (6) mit mindestens einer Schnittstellenschaltung (1) für den Anschluss einer Signalquelle (4), welche innerhalb einer integrierten Schaltung (5) und außerhalb der integrierten Schaltung (5) angeordnete Bauelemente aufweist, wobei die Schnittstellenschaltung (1) derart ausgestaltet ist, dass:

    • innerhalb der integrierten Schaltung (5) befindet sich eine spannungsabhängig geregelte Stromquelle oder Stromsenke (2),
    • außerhalb der integrierten Schaltung (5) befindet sich ein Bauelement (3) und
    • das Bauelement (3) ist zur Stromquelle oder Stromsenke (2) parallel geschaltet, wobei die Stromquelle oder Stromsenke (2) spannungsabhängig so geregelt wird, dass der Summenstrom (Iin) aus Strom (Ia) der Stromquelle oder Stromsenke (2) und Strom (Ip) aus dem passiven Bauelement (3) eine geringere Spannungsabhängigkeit aufweist als der Strom (Ip) vom passiven Bauelement (3) allein, derart, dass eine Umverteilung der Verlustleistung innerhalb der Schnittstellenschaltung (1) erfolgt.

2.  Baugruppe (6) nach Anspruch 1, wobei das Bauelement (3) als passives Bauelement (3) der Schnittstellenschaltung (1) ausgestaltet ist und aus einer oder mehreren passiven elektronischen Komponenten besteht.

3.  Baugruppe (6) nach Anspruch 1 oder 2, wobei die innerhalb einer integrierten Schaltung (5) befindliche Stromquelle oder Stromsenke (2) mehrerer Schnittstellenschaltungen (1) in einer gemeinsamen integrierten Schaltung (5) angeordnet sind.

4.  Baugruppe (6) nach einem der Ansprüche 1 bis 3, wobei das passive Bauelement (3) der Schnittstellenschaltung (1) ein Widerstand ist.

5.  Baugruppe (6) nach einem der Ansprüche 1 bis 4, wobei der Strom (Ia) der Stromquelle oder Stromsenke (2) durch Messen der an der Schnittstellenschaltung (1) anliegenden Spannung (Vin) in Stufen umgestellt wird.

6. Baugruppe (6) nach einem der Ansprüche 1 bis 5, wobei mittels linearer Schaltungstechnik der Schnittstellenschaltung (1) eine U/I- Kennlinie der jeweiligen Stromquelle oder Stromsenke (2) derart erzeugt wird, dass deren U/I-Kennlinie einer Konstantstromquelle (I0) mit parallelem, negativem Widerstand (Rneg) entspricht.

7. Baugruppe (6) nach Anspruch 1 oder Anspruch 6, wobei die Schnittstellenschaltung (1) einen Stromspiegel aufweist, welcher einen Eingangsstrom "in" entgegennimmt und einen Ausgangsstrom "out" nach Maßgabe eines Referenzstroms (Iref) erzeugt und wobei der Ausgangsstrom "out" dem N-Fachen Eingangsstrom "in" entspricht.

8. Baugruppe (6) nach einem oder mehreren der Ansprüche 1 bis 7, wobei die Schnittstellenschaltung (1) eine Operationsverstärkerschaltung (OPV) aufweist, welche die Spannung an einem bereits in der Baugruppe (6) vorhanden Spannungsteiler misst und proportional dazu den Sollwert der Stromquelle (2) derart verändern kann, dass die U/I-Kennlinie der jeweiligen Stromquelle oder Stromsenke (2) fallend ist.

9. Baugruppe (6) mit mindestens einer Schnittstellenschaltung (1) zur Verwendung der in IEC61131-2 Typ 1/2/3 beschriebenen digitalen Eingängen einer industriellen Steuerungsanlage nach einem der Ansprüche 1 bis 8.

10. Baugruppe (6) mit mindestens einer Schnittstellenschaltung (1) zur Verwendung bei einem in IEC61131-9 beschriebenen Empfängers eines IO-Link Transceivers nach einem der Ansprüche 1 bis 8.

11. Baugruppe (6) nach Anspruch 1 und 4, wobei die Kennlinie der Verlustleistung jeder Schnittstellenschaltung (1) hyperbolisch verläuft und die maximale Verlustleistung bei maximaler Spannung /2 auftritt, wobei an diesem Punkt sowohl Strom als auch Spannung nur halb so groß wie die maximale Verlustleistung einer Konstantstromquelle und die maximal auftretende Verlustleistung der gemeinsamen integrierten Schaltung (5) somit auf ca. ein Viertel reduziert ist.

12. Schnittstellenschaltung (1) nach Anspruch 1, welche derart ausgestaltet ist, dass mehrere Schnittstellenschaltungen (1) eine Baugruppe (6) bilden.

Fig. 1

Fig. 2

Fig. 3

Fig. 4

Fig. 5.1

Fig. 5.2

Fig. 6

$$V0 = Rneg * I0$$

Fig. 7

Fig. 8

**Europäisches Patentamt**
**European Patent Office**
**Office européen des brevets**

# EUROPÄISCHER RECHERCHENBERICHT

Nummer der Anmeldung

EP 20 02 0172

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | WO 2012/023022 A2 (INVENSYS SYS INC [US]; MAGU ASHISH [GB]) 23. Februar 2012 (2012-02-23) * Absätze [0024] - [0025], [0043] - [0050]; Abbildungen 3a,3b * ----- | 1-12 | INV. H03K17/30 G05B19/05 H03K17/60 H03K17/795 |
| X | US 2005/139791 A1 (BREINLINGER RICHARD H [US]) 30. Juni 2005 (2005-06-30) * Absätze [0020] - [0034]; Abbildungen 1,2 * ----- | 1-12 | |
| A | US 2014/125235 A1 (VAN DEN BERG ARJAN [NL] ET AL) 8. Mai 2014 (2014-05-08) * Absätze [0032] - [0036]; Abbildung 5 * ----- | 1-12 | |
| A | US 2016/219670 A1 (SUDHAUS ANDRE [DE]) 28. Juli 2016 (2016-07-28) * das ganze Dokument * ----- | 1-12 | |

**RECHERCHIERTE SACHGEBIETE (IPC)**

H03K
G05B

Der vorliegende Recherchenbericht wurde für alle Patentansprüche erstellt

| Recherchenort | Abschlußdatum der Recherche | Prüfer |
|---|---|---|
| Den Haag | 31. August 2020 | João Carlos Silva |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 20 02 0172

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-08-2020

| Im Recherchenbericht angeführtes Patentdokument | Datum der Veröffentlichung | Mitglied(er) der Patentfamilie | Datum der Veröffentlichung |
|---|---|---|---|
| WO 2012023022 A2 | 23-02-2012 | EP 2606405 A2<br>US 2012044015 A1<br>WO 2012023022 A2 | 26-06-2013<br>23-02-2012<br>23-02-2012 |
| US 2005139791 A1 | 30-06-2005 | KEINE | |
| US 2014125235 A1 | 08-05-2014 | CN 103369786 A<br>EP 2645818 A1<br>US 2014125235 A1 | 23-10-2013<br>02-10-2013<br>08-05-2014 |
| US 2016219670 A1 | 28-07-2016 | CN 105493629 A<br>DE 102014217070 A1<br>EP 3039945 A1<br>HK 1219832 A1<br>KR 20160047554 A<br>US 2016219670 A1<br>WO 2015028511 A1 | 13-04-2016<br>05-03-2015<br>06-07-2016<br>13-04-2017<br>02-05-2016<br>28-07-2016<br>05-03-2015 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- EP 1770456 B1
- EP 1770457 B1
- EP 3333656 A1
- US 9294063 B1
- US 9608635 B1